Europäisches Patentamt

European Patent Office

Office européen des brevets

(19)

(11) EP 0 799 426 B1

(12) EUROPÄISCHE PATENTSCHRIFT

(45) Veröffentlichungstag und Bekanntmachung des Hinweises auf die Patenterteilung:
31.03.1999 Patentblatt 1999/13

(51) Int Cl.⁶: **G01R 33/032**

(21) Anmeldenummer: 95940159.7

(86) Internationale Anmeldenummer:
PCT/DE95/01764

(22) Anmeldetag: 08.12.1995

(87) Internationale Veröffentlichungsnummer:
WO 96/20411 (04.07.1996 Gazette 1996/30)

(54) **VERFAHREN UND ANORDNUNG ZUM MESSEN EINES MAGNETFELDES UNTER AUSNUTZUNG DES FARADAY-EFFEKTS MIT KOMPENSATION VON INTENSITÄTSÄNDERUNGEN UND TEMPERATUREINFLÜSSEN**

PROCESS AND ARRANGEMENT FOR MEASURING A MAGNETIC FIELD USING THE FARADAY EFFECT WITH COMPENSATION OF VARIATIONS IN INTENSITY AND TEMPERATURE EFFECTS

PROCEDE ET DISPOSITIF POUR MESURER UN CHAMP MAGNETIQUE A L'AIDE DE L'EFFET FARADAY AVEC COMPENSATION DES VARIATIONS D'INTENSITE ET DES EFFETS DE LA TEMPERATURE

(84) Benannte Vertragsstaaten:
AT BE CH DE FR GB IT LI SE

(30) Priorität: 23.12.1994 DE 4446425

(43) Veröffentlichungstag der Anmeldung:
08.10.1997 Patentblatt 1997/41

(73) Patentinhaber: SIEMENS AKTIENGESELLSCHAFT
80333 München (DE)

(72) Erfinder:
• BOSSELMANN, Thomas
  D-91054 Erlangen (DE)
• MENKE, Peter
  D-91054 Erlangen (DE)

(56) Entgegenhaltungen:
WO-A-92/13280

• PROCEEDINGS OF THE INSTITUTION OF ELECTRICAL ENGINEERS, Bd. 141, Nr. 4, August 1994 STEVENAGE GB, Seiten 249-256, XP 000468763 A.YU & A.S.SIDDIQUI 'Practical Sagnac interferometer based fibre optic current sensor'
• ELECTRONICS LETTERS, Bd. 27, Nr. 13, Seiten 1131-1132, XP 000213764 WILLIAMS P A ET AL 'COMPENSATION FOR TEMPERATURE DEPENDENCE OF FARADAY EFFECT IN DIAMAGNETIC MATERIALS: APPLICATION TO OPTICAL FIBRE SENSORS'
• PATENT ABSTRACTS OF JAPAN vol. 009 no. 304 (P-409), 30. November 1985 & JP,A,60 138480 (HITACHI DENSEN KK) 23.Juli 1985,

## Beschreibung

Die Erfindung betrifft ein Verfahren und eine Anordnung zum Messen eines Magnetfeldes mit einer den Faraday-Effekt zeigenden Sensoreinrichtung, bei denen ein erstes Lichtsignal eine optische Reihenschaltung aus einer ersten optischen Übertragungsstrecke, einem ersten Polarisator, der Sensoreinrichtung, einem zweiten Polarisator und einer zweiten optischen Übertragungsstrecke durchläuft, und ein zweites Lichtsignal diese optische Reihenschaltung in zur Durchlaufrichtung des ersten Lichtsignals entgegengesetzter Richtung durchläuft.

Es sind optische Meßanordnungen und Meßverfahren zum Messen eines Magnetfeldes unter Ausnutzung des magnetooptischen Faraday-Effekts bekannt. Unter dem Faraday-Effekt versteht man die Drehung der Polarisationsebene von linear polarisiertem Licht in Abhängigkeit von einem Magnetfeld. Der Drehwinkel ist proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur- und wellenlängenabhängig. Zum Messen des Magnetfeldes wird eine Faraday-Sensoreinrichtung aus einem optisch transparenten Material wie beispielsweise Glas in dem Magnetfeld angeordnet. Das Magnetfeld bewirkt eine Drehung der Polarisationsebene von durch die Faraday-Sensoreinrichtung gesendetem linear polarisiertem Licht um einen Drehwinkel, die für ein Meßsignal ausgewertet werden kann. Eine bekannte Anwendung finden solche magnetooptischen Meßverfahren und Meßanordnungen beim Messen elektrischer Ströme. Die Faraday-Sensoreinrichtung wird dazu in der Nähe eines Stromleiters angeordnet und erfaßt das von einem Strom in dem Stromleiter erzeugte Magnetfeld. Im allgemeinen umgibt die Faraday-Sensoreinrichtung den Stromleiter, so daß das Meßlicht den Stromleiter in einem geschlossenen Weg umläuft. Der Betrag des Drehwinkels ist in diesem Fall in guter Näherung direkt proportional zur Amplitude des zu messenden Stromes. Die Faraday-Sensoreinrichtung kann als massiver Glasring um den Stromleiter ausgebildet sein oder auch den Stromleiter in Form einer Meßwicklung aus einer lichtleitenden Faser (Faserspule) mit wenigstens einer Windung umgeben.

Vorteile dieser magnetooptischen Meßanordnungen und Meßverfahren gegenüber herkömmlichen induktiven Stromwandlern sind die Potentialtrennung und die Unempfindlichkeit gegenüber elektromagnetischen Störungen. Probleme bereiten bei dem Einsatz von magnetooptischen Stromwandlern jedoch Einflüsse von mechanischen Vibrationen auf die Sensoreinrichtung und die optischen Zuleitungen, die zu die Messung verfälschenden Intensitätsänderungen führen können, und Einflüsse von Temperaturänderungen insbesondere in der Sensoreinrichtung.

Um Vibrationseinflüsse auf die Messung zu reduzieren, ist bekannt, zwei gegenläufige, d.h. in entgegengesetzten Richtungen sich ausbreitende, Lichtsignale durch eine Faraday-Sensoreinrichtung zu senden. Dieser bekannten Maßnahme liegt der Gedanke zugrunde, daß die von den beiden Lichtsignalen auf ihrem gemeinsamen Lichtweg erfahrene lineare Doppelbrechung infolge von Vibrationen als reziproker Effekt von dem nicht-reziproken Faraday-Effekt durch geeignete Signalverarbeitung unterschieden werden kann.

In einer ersten bekannten Ausführungsform werden zwei gegenläufige, linear polarisierte Lichtsignale durch eine optische Faserspule als Faraday-Sensoreinrichtung gesendet, die einen Stromleiter umgibt. Als optische Faser für die Faserspule ist eine mechanisch tordierte Faser (Twisted fibre) oder eine während des Ziehprozesses tordierte Faser mit einer hohen linearen Doppelbrechung (Spun-HiBi-fibre) vorgesehen. Die optische Faser weist neben dem Faraday-Effekt auch eine im Vergleich zum Faraday-Effekt hohe zirkuläre Doppelbrechung auf. Nach Durchlaufen der Sensoreinrichtung wird jedes der beiden Lichtsignale von einem polarisierenden Strahlteiler in zwei senkrecht zueinander polarisierte Anteile zerlegt. Mit den insgesamt vier Lichtanteilen wird von einer Signalverarbeitung ein Meßsignal für einen elektrischen Strom in dem Stromleiter abgeleitet, das im wesentlichen dem Quotienten aus dem Faraday-Meßwinkel und der zirkularen Doppelbrechung der Faser entspricht und damit unabhängig von einer linearen Doppelbrechung in der optischen Faser ist. Das so erhaltene Meßsignal ist damit zwar weitgehend frei von temperaturinduzierter linearen Doppelbrechung in der Sensoreinrichtung, jedoch ist das Meßsignal wegen der Temperaturabhängigkeit der zirkularen Doppelbrechung der Faser noch temperaturabhängig. Die beiden gegenläufigen Lichtsignale durchlaufen in dieser bekannten Ausführungsform nur die Faraday-Sensoreinrichtung auf einem gemeinsamen Lichtweg und werden beim Austritt aus der Faraday-Sensoreinrichtung wieder durch optische Koppler voneinander getrennt *(WO 92/13280)*.

In drei weiteren bekannten Ausführungsformen durchlaufen zwei Lichtsignale eine optische Reihenschaltung aus einer ersten Lichtleitfaser, einem ersten Polarisator, einer Faraday-Sensoreinrichtung, einem zweiten Polarisator und einer zweiten Lichtleitfaser in zueinander entgegengesetztem Umlaufsinn. Beide Lichtsignale werden nach Durchlaufen der optischen Reihenschaltung von entsprechenden photoelektrischen Wandlern in jeweils ein elektrisches Intensitätssignal umgewandelt.

Bei der ersten, aus der *US 4,916,387* bekannten Ausführungsform ist als Faraday-Sensoreinrichtung ein massiver Glasring vorgesehen, der den Stromleiter umgibt. Die Polarisationsachsen der beiden Polarisatoren sind um einen Winkel von 45° zueinander gedreht. Zur Kompensation von unerwünschten Intensitätsänderungen in den optischen Zuleitfasern wird bei diesem aus *US 4,916,387* bekannten Meßsystem davon ausgegangen, daß sich die unerwünschten Intensitätsänderungen (noise) und die Intensitätsänderungen aufgrund des Faraday-Effekts additiv überlagern mit unterschiedlichen Vorzeichen in den beiden elektrischen Intensitätssignalen und damit voneinander getrennt werden können. Eine genauere physikalische Betrachtung führt jedoch zu dem Ergebnis, daß mechanischen Bewegungen der beiden Lichtleitfasern zum Übertragen der beiden Lichtsignale sich im wesentlichen als zeitlich veränderliche Dämpfungsfaktoren in den Lichtintensitäten der beiden Lichtsignale auswirken. Wie solche unterschiedlichen Dämpfungsfaktoren in den beiden Lichtleitfasern ausgeglichen werden können, geht aus der US 4,916,387 nicht hervor.

Bei der zweiten, aus *Journal of Lightwave Technology,* Vol.12. *No. 10, October 1994, Seiten 1882 bis 1890* bekannten Ausführungsform ist eine Faserspule aus einer Single-Mode-Faser mit einer niedrigen Doppelbrechung als Faraday-Sensoreinrichtung vorgesehen. Die Polarisationsachsen der beiden Polarisatoren schließen einen von 0° verschiedenen Polarisatorwinkel miteinander ein, der vorzugsweise 45° beträgt. Licht einer einzigen Lichtquelle wird in die zwei Lichtsignale aufgeteilt, und diese Lichtsignale werden jeweils über einen optischen Koppler in die zugeordnete Lichtleitfaser eingekoppelt. Aus den beiden elektrischen Intensitätssignalen, die den Lichtintensitäten der zugeordneten Lichtsignale nach Durchlaufen der Reihenschaltung entsprechen, wird ein Meßsignal abgeleitet, das dem Quotienten aus der Differenz und der Summe der beiden Intensitätssignale entspricht. Damit können die Dämpfungsfaktoren der beiden Lichtleitfasern im wesentlichen kompensiert werden. Die Lichtintensitäten der beiden Lichtsignale beim Einkoppeln in die Reihenschaltung müssen allerdings genau gleich eingestellt werden.

Bei der dritten, aus den *Patent Abstracts of Japan, Vol.* 9, *No. 304 (p-409), 30.11.1985 der japanischen Patentanmeldung JP-A 60-138 480* bekannten Ausführungsform ist ein magnetfeldempfindliches Faraday-Element als Faraday-Sensoreinrichtung vorgesehen. Licht einer einzigen Lichtquelle wird über einen halbdurchlässigen Spiegel in zwei Lichtsignale aufgeteilt und diese Lichtsignale werden jeweils wiederum über halbdurchlässige Spiegel in die zugeordnete Lichtleitfaser eingekoppelt. Aus den beiden elektrischen Intensitätssignalen, die den Lichtintensitäten der zugeordneten Lichtsignale nach Durchlaufen der Reihenschaltung entsprechen, wird ein Meßsignal abgeleitet, das dem Quotienten aus der Differenz und der Summe der beiden Intensitätssignale entspricht. Die offenbarte Faraday-Sensoreinrichtung dient der hochgenauen Detektion von DC-Magnetfeldern und von AC-Magnetfeldern, die einen DC-Anteil enthalten. Die Lichtintensitäten der beiden Lichtsignale beim Einkoppeln in die Reihenschaltung müssen allerdings wiederum genau gleich eingestellt werden.

Eine Kompensation von Temperatureinflüssen auf das Meßsignal ist in US *4,916,387* oder *Journal of Lightwave Technology, Vol.12. No. 10, October 1994, Seiten 1882 bis 1890* nicht beschrieben. Vielmehr werden als Sensoreinrichtung temperaturunempfindliche Faserspulen verwendet. Die Fertigung solcher Faserspulen ist jedoch vergleichsweise problematisch.

Der Erfindung liegt die Aufgabe zugrunde, ein Meßverfahren und eine Meßanordnung zum Messen eines Magnetfeldes und insbesondere zum Messen eines elektrischen Stromes durch Messen dessen Magnetfeldes anzugeben, bei denen Intensitätsänderungen in den optischen Übertragungsstrecken für zwei gegenläufige Lichtsignale und Einflüsse von Temperaturänderungen praktisch eliminiert sind.

Diese Aufgabe wird gemäß der Erfindung gelöst mit den Merkmalen des Anspruchs 1 bzw. des Anspruchs 6. Zwei Lichtsignale durchlaufen eine optische Reihenschaltung aus einer ersten optischen Übertragungsstrecke, einem ersten Polarisator, einer Faraday-Sensoreinrichtung, einem zweiten Polarisator und einer zweiten optischen Übertragungstrecke in zueinander entgegengesetzten Durchlaufrichtungen. Als Meßsignal für das Magnetfeld wird von Auswertemitteln ein Quotient zweier linearer Funktionen der Lichtintensitäten der beiden Lichtsignale jeweils nach deren Durchlaufen der optischen Reihenschaltung ermittelt. Dieses Meßsignal ist im wesentlichen unabhängig von Intensitätsänderungen in den beiden optischen Übertragungsstrecken, jedoch im allgemeinen noch abhängig von der Temperatur insbesondere in der Sensoreinrichtung. Zur Kompensation von Temperatureinflüssen auf das Meßsignal werden nun die Polarisationsachse (Transmissionsachse) des ersten Polarisators unter einem ersten Polarisatorwinkel $\eta$ zu einer Eigenachse (Hauptachse) der linearen Doppelbrechung in der Faraday-Sensoreinrichtung eingestellt und die Polarisationsachse des zweiten Polarisators unter einem zweiten Polarisatorwinkel $\theta$ zu dieser Eigenachse in der Sensorrichtung eingestellt. Beide Polarisatorwinkel $\eta$ und $\theta$ werden so gewählt, daß sie wenigstens annähernd der Gleichung

$$\cos (2\eta + 2\theta) = -2/3 \qquad (1)$$

genügen.

Vorteilhafte Ausgestaltungen und Weiterbildungen des Verfahrens und der Anordnung gemäß der Erfindung ergeben sich aus den jeweils abhängigen Ansprüchen.

Zur weiteren Erläuterung der Erfindung wird auf die Zeichnung Bezug genommen, in deren

FIG 1   eine Meßanordnung zum Messen eines Magnetfeldes oder eines elektrischen Stromes mit einer Faraday-Sensoreinrichtung,

FIG 2   eine Meßanordnung zum Messen eines elektrischen Stromes mit einer Faraday-Sensoreinrichtung und besonderen Auswertemitteln und

FIG 3     die Polarisationsachsen der beiden Polarisatoren und eine Eigenachse der linearen Doppelbrechung in der Sensoreinrichtung

jeweils schematisch dargestellt sind. Einander entsprechende Teile sind mit denselben Bezugszeichen versehen.

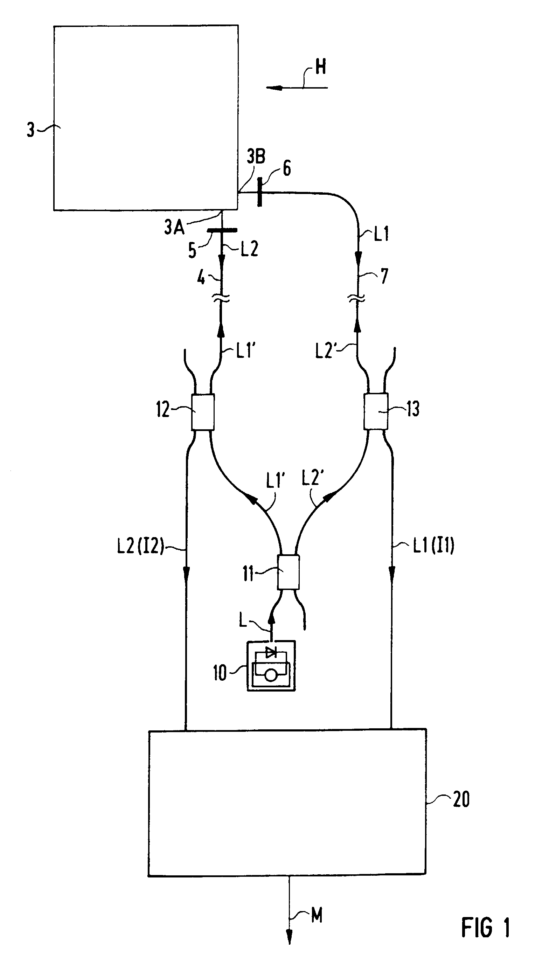

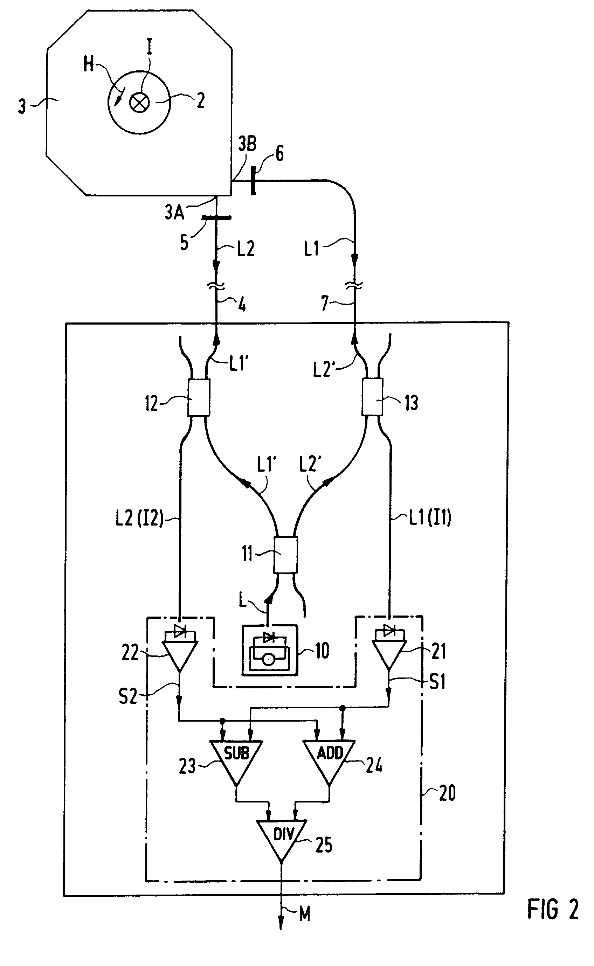

In den FIG. 1 und 2 sind eine Faraday-Sensoreinrichtung mit 3, zwei optische Übertragungsstrecken mit 4 und 7, zwei Polarisatoren mit 5 und 6, eine Lichtquelle mit 10, drei optische Koppler mit 11, 12 bzw. 13 und Auswertemittel mit 20 bezeichnet.

Die Faraday-Sensoreinrichtung 3 besteht aus wenigstens einem den magnetooptischen Faraday-Effekt zeigenden Material. Unter dem Einfluß eines die Sensoreinrichtung 3 wenigstens teilweise durchdringenden Magnetfeldes **H** wird die Polarisation von durch die Sensoreinrichtung 3 laufendem polarisierten Licht aufgrund des Faraday-Effekts geändert. Die Sensoreinrichtung 3 kann in an sich bekannter Weise mit einem oder mehreren massiven Körpern, vorzugsweise aus Glas, oder auch mit mindestens einer optischen Faser ausgebildet sein.

Die Sensoreinrichtung 3 weist zwei optische Anschlüsse 3A und 3B derart auf, daß an einem Anschluß 3A oder 3B eingekoppeltes Licht die Sensoreinrichtung 3 durchläuft und am jeweils anderen Anschluß 3B bzw. 3A wieder ausgekoppelt wird. Der erste Anschluß 3A der Sensoreinrichtung 3 ist über den ersten Polarisator 5 mit einem Ende der ersten optischen Übertragungsstrecke 4 optisch gekoppelt. Der zweite Anschluß 3B der Sensoreinrichtung 3 ist über den zweiten Polarisator 6 mit einem Ende der zweiten optischen Übertragungsstrecke 7 optisch gekoppelt. Das von der Sensoreinrichtung 3 abgewandte andere Ende der ersten Übertragungsstrecke 4 ist über den optischen Koppler 12 sowohl mit dem weiteren optischen Koppler 11 als auch mit den Auswertemitteln 20 optisch verbunden. Das von der Sensoreinrichtung 3 abgewandte andere Ende der zweiten Übertragungsstrecke 7 ist über den optischen Koppler 13 ebenfalls sowohl mit dem optischen Koppler 11 als auch mit den Auswertemitteln 20 optisch verbunden. Der optische Koppler 11 ist mit der Lichtquelle 10 optisch verbunden und teilt das Licht L der Lichtquelle 10 in zwei Lichtsignale L1' und L2' auf, die den Kopplern 12 bzw. 13 zugeführt werden und dann in die erste bzw. zweite Übertragungsstrecke 4 bzw. 7 eingekoppelt werden. Beide Lichtsignale L1' und L2' durchlaufen die optische Reihenschaltung aus erster Übertragungsstrecke 4, erstem Polarisator 5, Sensoreinrichtung 3, zweitem Polarisator 6 und zweiter Übertragungsstrecke 7 in zueinander entgegengesetzten Durchlaufrichtungen und werden als nun mit L1 bzw. L2 bezeichnete Lichtsignale wieder aus der Reihenschaltung ausgekoppelt. Die Lichtquelle 10 und die drei optischen Koppler 11, 12 und 13 bilden somit Mittel zum Senden von zwei gegensinnig die Reihenschaltung durchlaufenden Lichtsignalen L1 und L2 durch die Reihenschaltung.

Die Koppler 11, 12 und 13 können wenigstens teilweise auch durch optische Strahlteiler ersetzt werden. Außerdem können auch anstelle des Kopplers 11 und der einen Lichtquelle 10 auch zwei Lichtquellen vorgesehen sein, die jeweils ein Lichtsignal L1' bzw. L2' senden. Die Mittel zum Senden von zwei gegensinnig die Reihenschaltung durchlaufenden Lichtsignalen L1 und L2 durch die Reihenschaltung können ferner auch mit zwei abwechselnd als Sender und Empfänger betriebenen photoelektrischen Wandlern gebildet sein, die dann zugleich zum Umwandeln der Lichtsignale L1 und L2 nach Durchlaufen der Reihenschaltung in elektrische Intensitätssignale vorgesehen sind.

Das erste Lichtsignal L1' wird nach Durchlaufen der ersten Übertragungsstrecke 4 von dem ersten Polarisator 5 linear polarisiert und als nunmehr linear polarisiertes Lichtsignal L1' am Anschluß 3A in die Sensoreinrichtung 3 eingespeist. Beim Durchlaufen der Sensoreinrichtung 3 wird die Polarisationsebene des linear polarisierten ersten Lichtsignals L1' um einen vom Magnetfeld **H** abhängigen Faraday-Meßwinkel $\rho$ gedreht. Ein positiver Winkelwert entspreche dem mathematisch positiven Drehsinn, also dem Gegenuhrzeigersinn, ein negativer Winkelwert dagegen dem mathematisch negativen Drehsinn, d.h. dem Uhrzeigersinn, bezogen auf die Ausbreitungsrichtung des betrachteten Lichtsignals. Das in seiner Polarisationsebene um den Meßwinkel $\rho$ gedrehte erste Lichtsignal L1' wird nun dem zweiten Polarisator 6 zugeführt. Der zweite Polarisator 6 läßt nur den auf seine Polarisationsachse projizierten Anteil des ankommenden ersten Lichtsignals L1' durch und hat somit für das erste Lichtsignal L1' die Funktion eines Polarisationsanalysators. Der vom zweiten Polarisator 6 transmittierte Anteil des ersten Lichtsignals L1' ist nun mit L1 bezeichnet und wird über die zweite Übertragungsstrecke 7 und den Koppler 13 zu den Auswertemitteln 20 übertragen.

Das zweite Lichtsignal L2' passiert zunächst die zweite Übertragungsstrecke 7 und wird sodann von dem ersten Polarisator 5 linear polarisiert. Das linear polarisierte zweite Lichtsignal L2' wird nun am Anschluß 3A in die Sensoreinrichtung 3 eingekoppelt. Beim Durchlaufen der Sensoreinrichtung 3 wird die Polarisationsebene des linear polarisierten zweiten Lichtsignals L2' um einen vom Magnetfeld **H** abhängigen Faraday-Meßwinkel $-\rho$ gedreht, der wegen der nicht-reziproken Eigenschaft des Faraday-Effekts das entgegengesetzte Vorzeichen und den gleichen Betrag wie beim ersten Lichtsignal L1' hat. Das in seiner Polarisationsebene um den Meßwinkel $-\rho$ gedrehte zweite Lichtsignal L2' wird nun dem zweiten Polarisator 6 zugeführt. Der zweite Polarisator 6 läßt nur den auf seine Polarisationsachse projizierten Anteil des ankommenden zweiten Lichtsignals L2' durch und wirkt somit für das zweite Lichtsignal L2' als Polarisationsanalysator. Der vom zweiten Polarisator 6 transmittierte Anteil des zweiten Lichtsignals L2' ist nun mit L2 bezeichnet und wird über die erste Übertragungsstrecke 4 und den Koppler 12 zu den Auswertemitteln 20 übertragen.

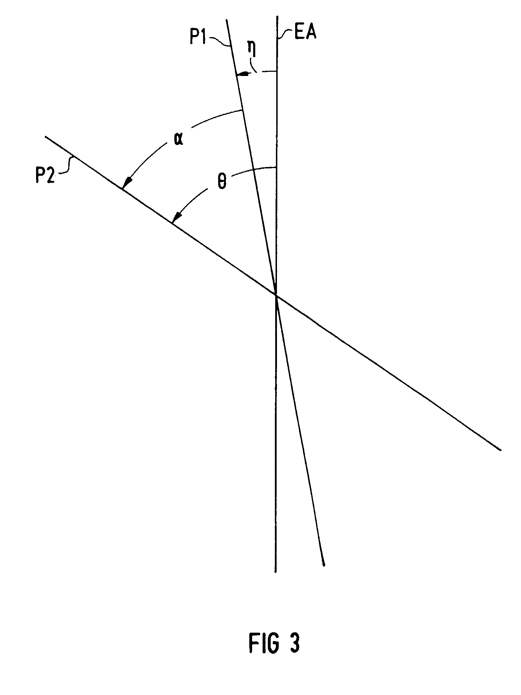

Die Polarisationsachsen (Transmissionsachsen) P1 und P2 der beiden Polarisatoren 5 und 6 schließen gemäß FIG 3 einen Winkel $\alpha$ zueinander ein, der ungleich einem ganzzahligen Vielfachen von 180° oder $\pi$ ist, bezogen auf die Durchlaufrichtung eines Lichtsignals L1' oder L2'. Die Polarisationsachsen P1 und P2 der beiden Polarisatoren 5 und 6 sind somit nicht parallel zueinander.

In einer besonders vorteilhaften Ausführungsform ist dieser Winkel $\alpha$ zwischen den Polarisationsachsen P1 und P2 der beiden Polarisatoren 5 und 6 zumindest annähernd gleich + 45° oder - 45° bzw. + $\pi/4$ bzw. - $\pi/4$. Der Arbeitspunkt für $\mathbf{H}$ = 0 ist dann in einem Bereich mit optimaler Linearität und Meßempfindlichkeit eingestellt.

Die Lichtintensitäten I1' und I2' der beiden Lichtsignale L1' und L2' vor dem Einkoppeln in die Reihenschaltung werden im allgemeinen in einem fest vorgegebenen Verhältnis zueinander eingestellt. Vorzugsweise sind beide Lichtintensitäten gleich, also I1' = I2'. In den dargestellten Ausführungsformen teilt der Koppler 11 das Licht L der Lichtquelle 10 dann in zwei gleiche Teile mit einem Kopplungsverhältnis 50%:50%.

Beim Durchlaufen der beiden Übertragungsstrecken 4 und 7 erfahren beide Lichtsignale L1' bzw. L1 und L2' bzw. L2 jeweils die gleichen Intensitätsänderungen, die insbesondere durch Dämpfungsverluste infolge von mechanischen Vibrationen verursacht werden können. Diese Intensitätsänderungen gehen im wesentlichen in Form von Dämpfungsfaktoren in die Lichtintensitäten I1 und I2 ein. Der reelle, im allgemeinen zeitabhängige Dämpfungsfaktor einer optischen Übertragungsstrecke ist definiert als das Verhältnis der Lichtintensität von an einem Ende der Übertragungsstrecke ankommendem Licht zu der Eingangslichtintensität des Lichts beim Einkoppeln in das andere Ende der Übertragungsstrecke. Sei A der reelle Dämpfungsfaktor der ersten Übertragungsstrecke 4 und B der Dämpfungsfaktor der zweiten Übertragungsstrecke 7. Dann gelten für die Lichtintensitäten I1 und I2 der beiden Lichtsignale L1 und L2 nach Durchlaufen der optischen Reihenschaltung die allgemeinen Beziehungen:

$$I1 = I0 \cdot A \cdot B \cdot \cos^2(\rho + \alpha) \qquad (2)$$

$$I2 = K \cdot I0 \cdot B \cdot A \cdot \cos^2(\rho - \alpha) \qquad (3).$$

I0 ist eine fest vorgegebene Ausgangsintensität. K ist ein Kopplungsfaktor, der sich in der dargestellten Ausführungsform aus den Kopplungsverhältnissen der Koppler 11, 12 und 13 ergibt. Wenn die Kopplungsverhältnisse aller Koppler 11, 12 und 13 jeweils 50%:50% sind, ist K=1. Die $\cos^2$-Terme in den Gleichungen (2) und (3) beschreiben die Abhängigkeit der Lichtintensität I1 bzw. I2 von dem Faraday-Meßwinkel $\rho$ für einen vorgegebenen Winkel $\alpha$ zwischen den beiden Polarisationsachsen der beiden Polarisatoren 5 und 6. Die Faktoren vor den $\cos^2$-Termen in den Ausdrücken für die beiden Lichtintensitäten I1 und I2 gemäß den Gleichungen (2) und (3) unterscheiden sich nur in dem Kopplungsfaktor K.

Die Dämpfungsfaktoren A und B der Übertragungsstrecken 4 und 7 werden nun eliminiert, indem die Auswertemittel 20 als Meßsignal M für das Magnetfeld $\mathbf{H}$ ein Quotientensignal der Gestalt

$$M = (a \cdot I1 + b \cdot I2 + c)/(d \cdot I1 + e \cdot I2 + f) \qquad (4)$$

aus zwei linearen Funktionen $a \cdot I1 + b \cdot I2 + c$ und $d \cdot I1 + e \cdot I2 + f$ der beiden Lichtintensitäten I1 und I2 mit den reellen Koeffizienten a, b, c, d, e und f ableiten. Dabei sind wenigstens entweder die Koeffizienten a und e oder die Koeffizienten b und d von Null verschieden.

Dieses Meßsignal M gemäß Gleichung (4) ist von insbesondere von Vibrationen verursachten Intensitätsänderungen in den Übertragungsstrecken 4 bzw. 7 praktisch unabhängig. Somit können in allen Ausführungsformen auch einfache, vergleichsweise preiswerte Telekommunikationslichtfasern (Multimode-Fasern) als Übertragungsstrecken 4 und 7 verwendet werden, da deren relativ hohe Dämpfungen und Vibrationsempfindlichkeiten im Meßsignal M kompensiert sind. Als Übertragungsstrecken 4 und 7 können aber auch andere Lichtwellenleiter oder Freistrahlanordnungen verwendet werden.

Die Koeffizienten a, b, c, d, e und f der linearen Funktionen im Zähler und Nenner von Gleichung (4) können insbesondere unterschiedlichen Eingangsintensitäten der beiden Lichtsignale beim Einkoppeln in die Reihenschaltung angepaßt werden. Vorzugsweise werden die Koeffizienten a, b, c, d, e und f für die gemäß den Gleichungen (2) und (3) bestimmten Lichtintensitäten I1 und I2 so angepaßt, daß sich ohne Berücksichtigung von linearen Doppelbrechungseffekten in der Sensoreinrichtung 3 ein Meßsignal

$$M \sim \sin(2\rho) \qquad (5)$$

ergibt, das im wesentlichen proportional zum Sinus des doppelten Faraday-Meßwinkels $\rho$ ist. Die Koeffizienten d, e und f der linearen Funktion $d \cdot I1 + e \cdot I2 + f$ im Nenner des Quotienten gemäß Gleichung (4) werden vorzugsweise so eingestellt, daß die lineare Funktion $d \cdot I1 + e \cdot I2 + f$ praktisch konstant und damit unabhängig vom Magnetfeld $\mathbf{H}$ ist.

In einer besonderen Ausführungsform wird ein Quotient

$$M = I1/I2 = \cos^2(\rho+\alpha) \, / \, (K \cdot \cos^2(\rho-\alpha)) \qquad (6a)$$

oder

$$M = I2/I1 = (K \cdot \cos^2(\rho-\alpha)) \, / \, \cos^2(\rho+\alpha) \qquad (6b)$$

aus beiden Lichtintensitäten I1 und I2 als Meßsignal M herangezogen. Dieser Quotient gemäß Gleichung (6a) oder (6b) ergibt sich aus dem allgemeinen Quotienten gemäß Gleichung (4), wenn man die Koeffizienten a=e=1 und b=c=d=f=0 bzw. a=c=e=f=0 und b=d=1 wählt. Dieses Meßsignal M hängt in vergleichsweise komplizierter, jedoch eindeutiger Weise von dem Meßwinkel ρ und damit vom Magnetfeld **H** ab.

Insbesondere bei wenigstens annähernd gleichen Eingangsintensitäten I1' und I2' beider Lichtsignale L1' und L2' kann in einer vorteilhaften Ausführungsform als Meßsignal M auch der Quotient

$$M = (I1-I2)/(I1+I2) \qquad (7)$$

aus einer Differenz I1-I2 (oder I2-I1) und der Summe I1+I2 beider Lichtintensitäten I1 und I2 nach Durchlaufen der Reihenschaltung verwendet werden. Dieses Meßsignal M ist dann wieder proportional zu sin(2ρ), wenn keine linearen Doppelbrechungseffekte in der Sensoreinrichtung 3 auftreten.

Das von den Dampfungsfaktoren A und B der Übertragungsstrecken 4 und 7 befreite Meßsignal M kann von den Auswertemitteln 20 auf verschiedene Arten aus den beiden Lichtintensitäten I1 und I2 der beiden gegenläufigen Lichtsignale L1 und L2 abgeleitet werden. Im allgemeinen werden beide Lichtsignale L1 und L2 von den Auswertemitteln 20 zunächst photoelektrisch in jeweils ein elektrisches Intensitätssignal umgewandelt, das ein direktes Maß für die Lichtintensität I1 bzw. I2 des jeweiligen Lichtsignals L1 bzw. L2 ist. Aus diesen beiden elektrischen Intensitätssignalen wird das Meßsignal M mit Hilfe einer Wertetabelle oder auch rechnerisch bestimmt. Die Auswertemittel 20 enthalten dazu entsprechende analoge oder digitale Bausteine.

In einer nicht dargestellten Ausführungsform werden die beiden elektrischen Intensitätssignale zunächst mit Hilfe eines Analog/Digital-Wandlers digitalisiert und die digitalisierten Signale werden von einem Mikroprozessor oder einem digitalen Signalprozessor gemäß einer der Gleichungen (4), (6a), (6b) oder (7) weiterverarbeitet.

Insbesondere zum rechnerischen Ermitteln des Meßsignals M als vorgegebene Funktion M(I1,I2) der beiden Lichtintensitäten I1 und I2 gemäß Gleichung (4), (6a), (6b) oder (7) können auch analoge Komponenten verwendet werden, die in der Regel schneller arbeiten als digitale Komponenten.

In FIG. 2 ist eine Ausführungsform der Meßanordnung dargestellt, die Auswertemittel 20 mit analogen Bausteinen enthält. Die Auswertemittel 20 umfassen in dieser Ausführungsform zwei photoelektrische Wandler 21 und 22, einen Subtrahierer 23, einen Addierer 24 und einen Dividierer 25. Der erste Wandler 21 ist optisch mit dem Koppler 13 verbunden und wandelt das erste Lichtsignal L1 nach dessen Durchlaufen der Reihenschaltung in ein erstes elektrisches Intensitätssignal S1 um, dessen Signalstärke der Lichtintensität I1 des ersten Lichtsignals L1 entspricht. Der zweite Wandler 22 ist mit dem Koppler 12 optisch verbunden und konvertiert das zweite Lichtsignal L2 nach dessen Durchlauf durch die Reihenschaltung in ein zweites elektrisches Intensitätssignal S2 als Maß für die Lichtintensität I2 des zweiten Lichtsignals L2. Beide elektrischen Intensitätssignale S1 und S2 werden jeweils einem Eingang des Subtrahierers 23 und des Addierers 24 zugeführt. Das Differenzsignal S1-S2 (oder S2-S1) am Ausgang des Subtrahierers 23 und das Summensignal S1+S2 am Ausgang des Addierers 24 werden jeweils einem Eingang des Dividierers 25 zugeführt. Das Ausgangssignal des Dividierers (S1-S2)/(S1+S2) wird als Meßsignal M herangezogen und auf einen Ausgang der Auswertemittel 20 geschaltet. Dieses Meßsignal M entspricht also der Gleichung (7).

Ein der allgemeineren Gleichung (4) genügendes Meßsignal M kann man mit Hilfe analoger Komponenten in einer nicht dargestellten Ausführungsform einfach dadurch erhalten, daß man vor die Eingänge von Subtrahierer 23 und Addierer 24 jeweils zusätzlich einen Verstärker schaltet und die Verstärkungsfaktoren dieser Verstärker den entsprechenden Koeffizienten a, -b für negatives b, d und e der beiden linearen Funktionen in Gleichung (4) anpaßt sowie weitere Addierer zum Hinzuaddieren des Koeffizienten c zu dem Ausgangssignal des Subtrahierers 23 gemäß dem Zähler in Gleichung (4) und des Koeffizienten f zu dem Ausgangssignal am Ausgang des Addierers 24 gemäß dem Nenner in Gleichung (4) vorsieht. Die Ausgangssignale der beiden weiteren Addierer werden dann den Eingängen des Dividierers 25 zugeführt. Ist b positiv, so wird anstelle des Subtrahierers 23 vorzugsweise ein weiterer Addierer eingesetzt.

Durch Anpassen der Koeffizienten a, b, c, d, e und f beim gemäß Gleichung (4) gebildeten Meßsignal M können insbesondere auch unterschiedliche Empfindlichkeiten der beiden photoelektrischen Wandler 21 und 22 ausgeglichen werden.

Die Meßanordnung gemäß FIG. 2 ist vorzugsweise zum Messen eines elektrischen Stromes I in wenigstens einem Stromleiter 2 vorgesehen. Die Faraday-Sensoreinrichtung 3 erfaßt das von diesem Strom I induktiv erzeugte Magnetfeld **H** und dreht die Polarisationsebenen der beiden Lichtsignale L1' und L2' um einen vom Magnetfeld **H** und damit vom Strom I abhängigen Meßwinkel ρ bzw. -ρ. In der in FIG. 2 dargestellten, besonders vorteilhaften Ausführungsform umgibt die Sensoreinrichtung 3 den Stromleiter 2, so daß beide Lichtsignale L1' und L2' den Strom I in einem praktisch geschlossenen Lichtpfad umlaufen. Der Meßwinkel ρ ist in diesem Fall direkt proportional zum elektrischen Strom I. Die Sensoreinrichtung 3 kann als massiver Glasring mit die Lichtsignale L1' und L2' umlenkenden inneren Reflexionsflächen oder auf andere bekannte Art und Weise ausgebildet sein. Die Auswertemittel 20 leiten aus den Lichtintensitäten I1 und I2 der beiden Lichtsignale L1 und L2 nach Durchlaufen der Reihenschaltung ein Meßsignal M für den elektrischen Strom I ab, das von Intensitätsänderungen in den beiden Übertragungsstrecken 4 und 7 weitgehend unabhängig ist.

Ein Problem bei der Messung eines Magnetfeldes **H** oder eines elektrischen Stromes I gemäß einem der beschriebenen Meßverfahren oder einer der beschriebenen Meßanordnungen stellen nun Tempereinflüsse in der Sensoreinrichtung 3 dar. Diese Temperatureinflüsse induzieren eine lineare Doppelbrechung δ als Funktion δ(T) der Temperatur T in der Sensoreinrichtung 3, die die Messung des Magnetfeldes **H** oder des elektrischen Stromes I verfälschen kann. Ferner können Temperaturänderungen auch die Verdet-Konstante und damit die Meßempfindlichkeit verändern.

Diese Temperaturabhängigkeit des Meßsignals M wird nun durch die im folgenden beschriebenen Maßnahmen zur Temperaturkompensation im wesentlichen beseitigt. Die Polarisationsachse P1 des ersten Polarisators 5 wird unter einem ersten Polarisatorwinkel η zu einer Eigenachse (Hauptachse, optische Achse) EA der linearen Doppelbrechung δ in der Sensoreinrichtung 3 eingestellt, und die Polarisationsachse P2 des zweiten Polarisators 6 wird unter einem zweiten Polarisatorwinkel θ zu dieser Eigenachse EA der linearen Doppelbrechung δ in der Sensoreinrichtung 3 eingestellt (vgl. FIG 3). Die beiden Polarisatorwinkel η und θ sind wenigstens annähernd gemäß der bereits erwähnten Gleichung

$$\cos(2\theta + 2\eta) = -2/3 \qquad (1)$$

bestimmt.

Eine Eigenachse der linearen Doppelbrechung δ ist dabei durch diejenige Polarisationsrichtung definiert, unter der in die Sensoreinrichtung 3 eingekoppeltes linear polarisiertes Licht die Sensoreinrichtung 3 praktisch unverändert wieder verläßt. Wird linear polarisiertes Licht dagegen mit einer nicht parallel zu einer der Eigenachsen der Sensoreinrichtung 3 gerichteten Polarisationsebene in die Sensoreinrichtung 3 eingekoppelt, so wird das Licht beim Durchlaufen der Sensoreinrichtung 3 aufgrund der linearen Doppelbrechung δ elliptisch polarisiert. Die im allgemeinen zueinander orthogonalen beiden Eigenachsen der linearen Doppelbrechung δ können in an sich bekannter Weise bestimmt werden. Beispielsweise kann die Sensoreinrichtung 3 zwischen einem Polarisator, beispielsweise dem Polarisator 5, und einem Analysator, beispielsweise dem Polarisator 6, angeordnet werden. Die Polarisationsachsen der beiden Polarisatoren werden senkrecht zueinander eingestellt. Nun werden in einer Ausführungsform die beiden Polarisationsachsen von Polarisator und Analysator gleichsinnig gegen eine Bezugsachse der Sensoreinrichtung 3 gedreht, bis die Intensität des vom Analysator transmittierten Lichts gleich Null ist (maximale Lichtauslöschung). Die Eigenachsen sind dann parallel zu den beiden Polarisationsachsen von Polarisator und Analysator. Alternativ dazu können in einer anderen Ausführungsform die beiden Polarisationsachsen auch gleichsinnig gegen die Bezugsachse der Sensoreinrichtung 3 gedreht werden, bis die Intensität des vom Analysator transmittierten Lichts maximal ist (minimale Lichtauslöschung). In diesem Fall ist das Licht beim Austreten aus der Sensoreinrichtung 3 zirkular polarisiert. Die Eigenachsen der linearen Doppelbrechung δ liegen dann um 45° bzw. -45° versetzt zur Polarisationsachse des Analysators.

Abweichungen von den die Gleichung (1) exakt erfüllenden Winkelwerten für die beiden Polarisatorwinkel η und θ sind möglich, insbesondere bei hoher linearer und/oder zirkularer Doppelbrechung in der Sensoreinrichtung 3, und können im allgemeinen bis zu etwa 5° betragen. Aus der Beziehung (1) folgt insbesondere, daß die Polarisationsachsen P1 und P2 beider Polarisatoren 5 und 6 nicht parallel zu der Eigenachse EA der linearen Doppelbrechung δ in der Sensoreinrichtung 3 gerichtet sind.

Der Winkel α zwischen den beiden Polarisationsachsen der beiden Polarisatoren 5 und 6 ist gleich der Differenz η-θ oder θ-η, je nachdem, ob man als Bezugssystem die Durchlaufrichtung des ersten Lichtsignals L1' oder des zweiten Lichtsignals L2' wählt, und unter Berücksichtigung der dem mathematischen Drehsinn entsprechenden Vorzeichen der beiden Polarisatorwinkel η und θ. Vorzugsweise wird der Differenzwinkel α so eingestellt, daß wenigstens annähernd die Beziehung

$$\sin(2\alpha) = \sin(\pm 2(\theta - \eta)) = \pm 1 \qquad (8)$$

gilt. Diese Gleichung (8) erfüllende Polarisatorwinkel η und θ entsprechen der bereits erwähnten Ausführungsform, bei der der Differenzwinkel α auf seinen bevorzugten Wert + 45° oder - 45° eingestellt ist. Als beide Gleichungen (1) und (8) zugleich erfüllende Winkelwerte für die beiden Polarisatorwinkel η und θ können beispielsweise η = 10,45° und θ = 55,45° gewählt werden, wie in FIG 3 dargestellt.

Das mit wenigstens annähernd gemäß Gleichung (1) eingestellten Polarisatorwinkeln η und θ ermittelte Meßsignal M entspricht nun auch bei sich ändernden Temperaturen in der Sensoreinrichtung 3 im wesentlichen dem Meßsignal ohne lineare Doppelbrechung δ, im Falle eines gemäß Gleichung (4) oder (7) hergeleiteten Meßsignals M also einer zu sin(2ρ) proportionalen Größe gemäß der Beziehung (5).

Die beiden gemäß Gleichung (1) optimalen Polarisatorwinkel η und θ der beiden Polarisatoren 5 bzw. 6 können in einer besonderen Ausführungsform einfach so eingestellt werden, daß man in einer Eichmessung das Meßsignal M in seiner Abhängigkeit von der Temperatur mit seinem zu erwartenden Sollwert ohne lineare Doppelbrechung δ, insbesondere gemäß der Beziehung (5), für zwei vorgegebene Polarisatorwinkel η und θ als Parameter vergleicht und die beiden Polarisatorwinkel η und θ so lange verändert, bis das aktuelle Meßsignal M mit dem praktisch temperaturunabhängigen Sollwert übereinstimmt.

Ein Vorteil der Temperaturkompensation durch Einstellen der Polarisatorwinkel η und θ ist die hohe Bandbreite beim Messen von Magnetfeldern **H** oder elektrische Strömen I. Das Frequenzspektrum der zu messenden Magnetfelder **H** oder elektrischen Ströme I wird durch die Maßnahmen zur Temperaturkompensation nämlich prinzipiell nicht beschränkt.

**Patentansprüche**

1. Verfahren zum Messen eines Magnetfeldes **(H)** mit einer den Faraday-Effekt zeigenden Sensoreinrichtung (3), bei dem

    a) ein erstes Lichtsignal (L1) eine optische Reihenschaltung aus einer ersten optischen Übertragungsstrecke (4), einem ersten Polarisator (5), der Sensoreinrichtung (3), einem zweiten Polarisator (6) und einer zweiten optischen Übertragungsstrecke (7) durchläuft,
    b) ein zweites Lichtsignal (L2) diese optische Reihenschaltung in zur Durchlaufrichtung des ersten Lichtsignals (L1) entgegengesetzter Richtung durchläuft,

    **dadurch gekennzeichnet,** daß

    c) die Polarisationsachse (P1) des ersten Polarisators (5) um einen ersten Polarisatorwinkel η gegen eine Eigenachse (EA) der linearen Doppelbrechung in der Sensoreinrichtung (3) gedreht eingestellt wird und die Polarisationsachse (P2) des zweiten Polarisators (6) um einen zweiten Polarisatorwinkel θ gegen diese Eigenachse (EA) gedreht eingestellt wird, wobei die beiden Polarisatorwinkel η und θ wenigstens annähernd die Beziehung

    $$\cos (2\theta + 2\eta) = -2/3$$

    erfüllen, und
    d) ein Meßsignal (M) für das Magnetfeld **(H)** ermittelt wird, das einem Quotienten $(a \cdot I1 + b \cdot I2 + c)/(d \cdot I1 + e \cdot I2 + f)$ zweier linearer Funktionen der Lichtintensitäten (I1,I2) der beiden Lichtsignale (L1,L2) jeweils nach deren Durchlaufen der optischen Reihenschaltung entspricht, wobei die Werte a, b, c, d, e und f reelle Koeffizienten darstellen.

2. Verfahren nach Anspruch 1, bei dem das Meßsignal (M) proportional zum Quotienten $((I1-I2)/(I1+I2))$ aus einer Differenz und der Summe der beiden Lichtintensitäten (I1,I2) ist.

3. Verfahren nach Anspruch 1, bei dem das Meßsignal (M) proportional zu einem Quotienten (I1/I2 oder I2/I1) der beiden Lichtintensitäten (I1,I2) ist.

4. Verfahren nach einem der vorhergehenden Ansprüche, bei dem die Polarisatorwinkel η und θ der Polarisationsachsen (P1,P2) der beiden Polarisatoren (5,6) zur Eigenachse (EA) der linearen Doppelbrechung in der Sensoreinrichtung (3) so eingestellt werden, daß wenigstens annähernd

    $$\sin (2\theta - 2\eta) = \pm 1$$

    erfüllt ist.

5. Verfahren nach einem der vorhergehenden Ansprüche, bei dem das Magnetfeld **(H)** eines elektrischen Stromes (I) gemessen wird und das Meßsignal (M) als Maß für den elektrischen Strom (I) herangezogen wird.

6. Anordnung zum Messen eines Magnetfeldes **(H)** mit

    a) einer optischen Reihenschaltung aus einer ersten optischen Übertragungsstrecke (4), einem ersten Polarisator (5), einer den Faraday-Effekt zeigenden Sensoreinrichtung (3), einem zweiten Polarisator (6) und einer zweiten optischen Übertragungsstrecke (7),
    b) Mitteln (10,11,12,13) zum Senden von zwei Lichtsignalen (L1,L2) durch die Reihenschaltung, die die Reihenschaltung gegensinnig durchlaufen,

    **gekennzeichnet** durch

    c) Auswertemittel (20) zum Ableiten eines Meßsignals (M) für das Magnetfeld **(H)**, das einem Quotienten $(a \cdot I1 + b \cdot I2 + c)/(d \cdot I1 + e \cdot I2 + f)$ zweier linearer Funktionen der Lichtintensitäten (I1,I2) der beiden Lichtsignale (L1,L2) jeweils nach deren Durchlaufen der optischen Reihenschaltung entspricht, wobei die Werte a, b, c, d, e und f reelle Koeffizienten darstellen, und

wobei

d) die Polarisationsachse (P1) des ersten Polarisators (5) um einen ersten Polarisatorwinkel η gegen eine Eigenachse (EA) der linearen Doppelbrechung in der Sensoreinrichtung (3) gedreht ist und die Polarisationsachse (P2) des zweiten Polarisators (6) um einen zweiten Polarisatorwinkel θ gegen diese Eigenachse (EA) gedreht ist und die beiden Polarisatorwinkel η und θ wenigstens annähernd die Beziehung

$$\cos(2\theta + 2\eta) = -2/3$$

erfüllen.

7. Anordnung nach Anspruch 6, bei der die beiden optischen Übertragungsstrecken (4,7) mit Multimode-Lichtleitern gebildet sind.

8. Anordnung nach Anspruch 6 oder Anspruch 7, bei der die Auswertemittel (20) ein Meßsignal (M) ableiten, das proportional zum Quotienten $((I1-I2)/(I1+I2))$ aus einer Differenz und der Summe der beiden Lichtintensitäten (I1,I2) ist.

9. Anordnung nach Anspruch 6 oder Anspruch 7, bei der die Auswertemittel (20) ein Meßsignal (M) ableiten, das proportional zu einem Quotienten (I1/I2 oder I2/I1) der beiden Lichtintensitäten (I1,I2) ist.

10. Anordnung nach einem der Ansprüche 6 bis 9, bei der die Polarisatorwinkel η und θ der Polarisationsachsen (P1,P2) der beiden Polarisatoren (5,6) zur Eigenachse (EA) der linearen Doppelbrechung in der Sensoreinrichtung (3) wenigstens annähernd gemäß der Beziehung

$$\sin(2\theta - 2\eta) = \pm 1$$

eingestellt sind.

11. Anordnung nach einem der Ansprüche 6 bis 10, bei der die Sensoreinrichtung (3) im Magnetfeld **(H)** eines elektrischen Stromes (I) angeordnet ist und die Auswertemittel (20) das Meßsignal (M) als Maß für den elektrischen Strom (I) ableiten.

## Claims

1. Method for measuring a magnetic field (H), using a sensor device (3) exhibiting the Faraday effect, in which method

a) a first light signal (L1) passes through an optical series circuit comprising a first optical transmission path (4), a first polarizer (5), the sensor device (3), a second polarizer (6) and a second optical transmission path (7),

b) a second light signal (L2) passes through this optical series circuit in a direction opposed to the passage direction of the first light signal (L1),

characterized in that

c) the axis of polarization (P1) of the first polarizer (5) is set rotated through a first polarizer angle η in relation to an intrinsic axis (EA) of the linear birefringence in the sensor device (3), and the axis of polarization (P2) of the second polarizer (6) is set rotated through a second polarizer angle θ in relation to this intrinsic axis (EA), the two polarizer angles η and θ at least approximately satisfying the relationship

$$\cos(2\theta + 2\eta) = -2/3,$$

and

d) a measured signal (M), which corresponds to a quotient $(a \cdot I1 + b \cdot I2 + c)/(d \cdot I1 + e \cdot I2 + f)$ of two linear functions of the light intensities (I1, I2) of the two light signals (L1, L2), in each case after their passage through the optical series circuit, is determined for the magnetic field (H), the values a, b, c, d, e and f representing real coefficients.

2. Method according to Claim 1, in which the measured signal (M) is proportional to the quotient $((I1-I2)/(I1+I2))$ of a difference and the sum of the two light intensities (I1, I2).

3. Method according to Claim 1, in which the measured signal (M) is proportional to a quotient (I1/I2 or I2/I1) of the two light intensities (I1, I2).

4. Method according to one of the preceding claims, in which the polarizer angles η and θ of the axes of polarization (P1, P2) of the two polarizers (5, 6) are set in relation to the intrinsic axis (EA) of the linear birefringence in the sensor device (3) in such a way that

$$\sin(2\theta - 2\eta) = \pm 1$$

is at least approximately satisfied.

5. Method according to one of the preceding claims, in which the magnetic field (H) of an electric current (I) is measured, and the measured signal (M) is used as a measure of the electric current (I).

6. Arrangement for measuring a magnetic field (H), having

   a) an optical series circuit comprising a first optical transmission path (4), a first polarizer (5), a sensor device (3) exhibiting the Faraday effect, a second polarizer (6) and a second optical transmission path (7),
   b) means (10, 11, 12, 13) for transmitting two light signals (L1, L2) through the series circuit, the light signals passing through the series circuit in opposite directions,

   characterized by

   c) evaluation means (20) for deriving a measured signal (M) for the magnetic field (H), which corresponds to a quotient $(a \cdot I1 + b \cdot I2 + c)/(d \cdot I1 + e \cdot I2 + f)$ of two linear functions of the light intensities (I1, I2) of the two light signals (L1, L2), in each case after their passage through the optical series circuit, the values a, b, c, d, e and f representing real coefficients, and
   d) the axis of polarization (P1) of the first polarizer (5) being rotated through a first polarizer angle $\eta$ in relation to an intrinsic axis (EA) of the linear birefringence in the sensor device (3), and the axis of polarization (P2) of the second polarizer (6) being rotated through a second polarizer angle $\theta$ in relation to this intrinsic axis (EA), and the two polarizer angles $\eta$ and $\theta$ at least approximately satisfying the relationship

   $$\cos (2\theta + 2\eta) = - 2/3.$$

7. Arrangement according to Claim 6, in which the two optical transmission paths (4, 7) are formed with multimode optical fibres.

8. Arrangement according to Claim 6 or Claim 7, in which the evaluation means (20) derive a measured signal (M) which is proportional to the quotient $((I1-I2)/(I1+I2))$ of a difference and the sum of the two light intensities (I1, I2).

9. Arrangement according to Claim 6 or Claim 7, in which the evaluation means (20) derive a measured signal (M) which is proportional to a quotient (I1/I2 or I2/I1) of the two light intensities (I1, I2).

10. Arrangement according to one of Claims 6 to 9, in which the polarizer angles $\eta$ and $\theta$ of the axes of polarization (P1, P2) of the two polarizers (5, 6) are set in relation to the intrinsic axis (EA) of the linear birefringence in the sensor device (3) at least approximately in accordance with the relationship

    $$\sin (2\theta - 2\eta) = \pm 1.$$

11. Arrangement according to one of Claims 6 to 10, in which the sensor device (3) is arranged in the magnetic field (H) of an electric current (I), and the evaluation means (20) derive the measured signal (M) as a measure of the electric current (I).

## Revendications

1. Procédé de mesure d'un champ (H) magnétique par un dispositif (3) à détecteur indiquant l'effet Faraday dans lequel

   a) on fait passer un premier signal (L1) lumineux dans un circuit série optique constitué d'un premier trajet (4) optique de transmission, d'un premier polariseur (5), du dispositif (3) à détecteur, d'un deuxième polariseur (6) et d'un deuxième trajet (7) optique de transmission,
   b) on fait passer, en sens inverse du sens de passage du premier signal (L1) lumineux, un deuxième signal (L2) lumineux dans ce circuit série optique,

   caractérisé, en ce que

   c) l'axe (P1) de polarisation du premier polariseur (5) est tourné d'un premier angle $\eta$ de polariseur par rapport à un axe (EA) propre de la biréfringence linéaire dans le dispositif (3) à détecteur, et l'axe (P2) de polarisation du deuxième polariseur (6) est tourné d'un deuxième angle $\theta$ de polariseur par rapport à l'axe (EA) propre, les deux angles $\eta$ et $\theta$ de polariseur satisfaisant au moins approximativement à la relation

   $$\cos (2\theta + 2\eta) = - 2/3$$

   et,
   d) on détermine un signal (M) de mesure du champ (H) magnétique, qui correspond à un quotient $(a.I1 + b.I2 + c) / (d.I1 + e.I2 + f)$ de deux fonctions linéaires (11, 12) des intensités lumineuses des deux signaux (L1, L2) lumineux, chacune après leur passage dans le circuit série optique, les valeurs a, b, c, d, e et f représentant des coefficients réels.

2. Procédé suivant la revendication 1, dans lequel le signal de mesure est proportionnel au quotient

((l1-l2) / (l1+l2) ) constitué d'une différence et de la somme des deux intensités (l1, l2) lumineuses.

3. Procédé suivant la revendication 1, dans lequel le signal (M) de mesure est proportionnel à un quotient (l1/l2 ou l2/l1), des deux intensités (l1/l2) lumineuses.

4. Procédé suivant l'une des revendications précédentes, dans lequel les angles η et θ des axes (P1, P2) de polarisation des deux polariseurs (5, 6) avec l'axe (EA) propre de la biréfringence linéaire du dispositif (3) à détecteur sont réglés de manière à satisfaire approximativement à la relation

$$\sin(2\theta - 2\eta) = \pm 1$$

5. Procédé suivant l'une des revendications précédentes, dans lequel on mesure le champ (H) magnétique d'un courant (I) électrique, et on utilise le signal (M) de mesure comme mesure du courant (I) électrique.

6. Dispositif de mesure d'un champ (H) magnétique comprenant

   a) un circuit série optique constitué, d'un premier trajet (4) optique de transmission, d'un premier polariseur (5). d'un dispositif (3) à détecteur indiquant l'effet Faraday, d'un deuxième polariseur (6) et d'un deuxième trajet (7) optique de transmission,
   b) de moyens (10, 11, 12 13) d'émission de deux signaux (L1, L2) lumineux dans le circuit série, qui passent dans le circuit série en sens inverse,

   caractérisé par,

   c) des moyens (20) d'exploitation pour déduire un signal (M) de mesure du champ (H) magnétique, qui représente un quotient (a.l1+b.l2+c) / (d.l1+e.l2+f) de deux fonctions linéaires des intensités (l1, l2) lumineuses des deux signaux (L1, L2) lumineux, chacune après leur passage dans le circuit série optique, les valeurs a, b, c, d, e, et f étant des coefficients réels et dans lequel
   d) l'axe (P1) de polarisation du premier polariseur (5) est tourné d'un premier angle η de polarisation par rapport à un axe (EA) propre de la biréfringence linéaire du dispositif (3) à détecteur, et l'axe (P2) de polarisation du deuxième polariseur (6) est tourné d'un deuxième angle θ de polarisation par rapport à cet axe (EA) propre, et les deux angles η et θ de polariseur, satisfont au moins approximativement à

la relation

$$\cos(2\theta + 2\eta) = -2/3$$

7. Dispositif suivant la revendication 6, dans lequel les deux trajets (4, 7) optiques de transmission sont formés de fibres optiques multimodes.

8. Dispositif suivant la revendication 6 ou 7, dans lequel les moyens (20) d'exploitation déduisent un signal (M) de mesure, qui est proportionnel au quotient ((l1-l2) / (l1+l1)) d'une différence et de la somme des deux intensités (l1, l2) lumineuses.

9. Dispositif suivant la revendication 6 ou 7, dans lequel les moyens (20) d'exploitation déduisent un signal (M) de mesure, qui est proportionnel à un quotient (l1/l2 ou l2/l1) des deux intensités (l1/l2) lumineuses.

10. Dispositif suivant l'une des revendications 6 à 9, dans lequel les angles η et θ de polarisation des axes (P1, P2) de polarisation des deux polariseurs (5, 6) par rapport à l'axe (EA) propre de la biréfringence linéaire du dispositif (3) à détecteur satisfont au moins approximativement à la relation

$$\sin(2\theta - 2\eta) = \pm 1$$

11. Dispositif suivant l'une des revendications 6 à 10 dans lequel le dispositif (3) à détecteur est disposé dans le champ (H) magnétique d'un courant (I) électrique et les moyens (20) d'exploitation déduisent le signal le (M) de mesure en tant que mesure du courant (I) électrique.

FIG 1

FIG 2

FIG 3